# NEUE EUROPÄISCHE PATENTSCHRIFT

(11) **EP 0 167 664 B2**
(45) Veröffentlichungstag und Bekanntmachung des Hinweises auf die Entscheidung über den Einspruch: **26.02.1997**
(45) Hinweis auf die Patenterteilung: 04.03.1992
(21) Anmeldenummer: 84113608.8
(22) Anmeldetag: 10.11.1984
(51) Int. Cl.: H03J 9/06

(54) **Einrichtung zur Einstellung eines elektronischen Geräts, insbesondere eines Fernsehgeräts**
Device for adjusting an electronic apparatus, particularly a television apparatus
Dispositif pour le réglage d'un appareil électronique, en particulier d'un appareil de télévision

(30) Priorität: 17.03.1984 DE 3409855
(43) Veröffentlichungstag der Anmeldung: 15.01.1986
(73) Patentinhaber: Blaupunkt-Werke GmbH, D-31132 Hildesheim (DE)
(72) Erfinder: Baum, Wolfgang, Ing. grad., D-3200 Hildesheim (DE)

(56) Entgegenhaltungen:
- EP-A- 0 026 486
- EP-A- 0 136 060
- DE-A- 2 744 057
- DE-A- 2 755 596
- DE-A- 3 105 301
- DE-A- 3 228 354
- GB-A- 2 070 828
- FUNKSCHAU, Band 9, 1978, Seiten 405-407, München, DE; K. KNUTH: "Farbempfänger mit einfacher Vorprogrammierung"

## Beschreibung

Das Schutzrecht betrifft ein neues Fernsehgerät mit den Merkmalen des Oberbegriffs des Anspruchs 1.

Bekanntlich sind bei Fernsehgeräten zum einen Grundbetriebswerte mittels Justageschaltungen und zum anderen individuelle, dem Bedürfnis des Benutzers entsprechende Betriebswerte mittels Einstellschaltungen wählbar. Bei solchen Fernsehgeräten wird vor der Auslieferung werkseitig ein Abgleich durchgeführt, wobei die Grundbetriebswerte, wie Bildhöhe, Linearität usw. einjustiert werden. Neben diesen Grundbetriebswerten stehen die variablen Bedieneinstellungen, wie Lautstärke, Helligkeit usw., die von dem Benutzer beim Betrieb des Fernsehgerätes individuell vorgenommen werden können.

Das für die variablen Einstellungen durch den Benutzer benötigte Bedienteil kann sowohl eine am Fernsehgerät ortsfest angebrachte Bordbedienung als auch die übliche Fernbedienung sein.

In neuerer Zeit werden Fernsehgeräte zunehmend mit digitalen Schaltungen ausgerüstet. Solche Fernsehgeräte besitzen als Einstellschaltungen Prozessoren, die über Datensammelleitungen per zugeordneter Adressen anwählbar und ansteuerbar sind. Mit Hilfe dieser Prozessoren kann beispielsweise von dem Benutzer mit Hilfe des Fernbedienteils die Lautstärke eingestellt werden. Aber auch die Einstellung der Grundbetriebswerte erfolgt über Prozessoren, die allerdings nicht über den Fernbedienteil oder die Bordbedienung zugänglich sind.

Nach einer Reparatur eines Fernsehgerätes ist gelegentlich erforderlich, in den Justageschaltungen die Grundbetriebswerte neu einzustellen bzw. zu korrigieren. Um die entsprechendenen Einstellungen vornehmen zu können, ist man bisher in der Weise vorgegangen, an eine Schnittstelle der zu den entsprechenden Prozessoren führenden Datensammelleitung einzugreifen und hier ein externes Servicegerät anzuschließen. Mit diesem Servicegerät können dann in an sich bekannter Weise die gewünschten Prozessoren angewählt und angesteuert werden, um die Service-Einstellungen vorzunehmen.

Die beschriebene Methode hat sich in der Praxis allerdings als aufwendig und kostenintensiv erwiesen. Wegen der auf dem Markt befindlichen unterschiedlichen Fernsehgeräte ist ein Reparaturbetrieb gezwungen, mehrere solcher teuren Servicegeräte anzuschaffen, um die Serviceeinstellungen bei den unterschiedlichen Gerätetypen vornehmen zu können. Ferner bedingt die Schnittstelle in der Datensammelleitung bzw. die Notwendigkeit der wahlweisen Zugängigkeit einer solchen Schnittstelle einen erhöhten Schaltungsaufwand bei dem betreffenden Fernsehgerät.

Andererseits ist die Verwendung eines externen Servicegerätes mit Anschlußmöglichkeit an die Schnittstelle in zunehmendem Maße unerläßlich, da die Fernsehgeräte mit Prozessoren für die Einstellungen keine von außen zugänglichen Einstellhilfen in Form von Potentiometern usw., wie sie früher üblich gewesen sind, bsitzen. So läßt sich etwa die Bildhöhe bei einem digitalen Fernsehgerät nicht mehr in herkömmlicher Weise extern durch Betätigung eines Drehknopfes einstellen, vielmehr kann die Justage nur über den zugeordneten Prozessor erfolgen. Es ist daher unerläßlich, für diese Einstellungen die Möglichkeit der Ansteuerung der zugeordneten Prozessoren zu schaffen, was durch die erwähnten nachteiligen Servicegeräte geschieht.

Durch die vorveröffentlichte GB-A- 2 070 828 ist auch ein Fernsehgerät bekannt geworden, dessen Grundbetriebswerte in zugeordneten Justageschaltungen über ein mehrere Bedienelemente aufweisendes Fernbedienteil einstellbar sind. Das Fernsehgerät verfügt über einen eingebauten Mode-Umschalter, mit dessen Hilfe sich zwei verschiedene Bedienarten wählen lassen. In der einen Bedienart werden die Einstellschaltungen durch die Bedienelemente angesteuert, in der zweiten Bedienart dagegen die Justageschaltungen.

Der eingebaute, einen Schaltkontakt aufweisende Mode-Umschalter muß aus Sicherheitsgründen für den Benutzer unzugänglich plaziert sein, weil dieser sonst - wenn auch unabsichtlich - die Grundbetriebswerte verstellen könnte. Die unzugängliche Plazierung des Mode-Umschalters führt zu dem Nachteil, daß das Fernsehgerät im Reparaturfall von Anfang an geöffnet werden muß, damit der Zugang zu dem Umschalter möglich ist.

Aus der DE-A- 32 28 354 ist eine benutzenführende Bedienung bei Geräten der Unterhaltungstechnik bekannt, bei denen zur Justierung in digitaler Form als Zahlenwerte vorgegebene Koeffizienten verändert werden. Ggts. nach Eingabe eines Sperrcodes werden Hinweise zur Justierung in den Bildschirm eingeblendet. Die Eingabe neuer Koeffizienten erfolge dann über das Fernbedienteil. Zuvor ist es erforderlich, daß eine bestimmte Gruppe von Zusatzfunktionen ausgewählt wird, indem zuerst die Gruppenrauswahltaste und anschließend eine weitere Taste oder eine Kombination von weiteren Tasten gedrückt wird.

Der Erfindung lag die Aufgabe zugrunde, einen einfacheren Zugang zu dem Mode-Umschalter zu schaffen, der trotzdem gleich zuverlässig vor einer Fehlbedienung geschützt ist.

Die Erfindung löst diese Aufgabe mit den im Anspruch 1 genannten Mitteln.

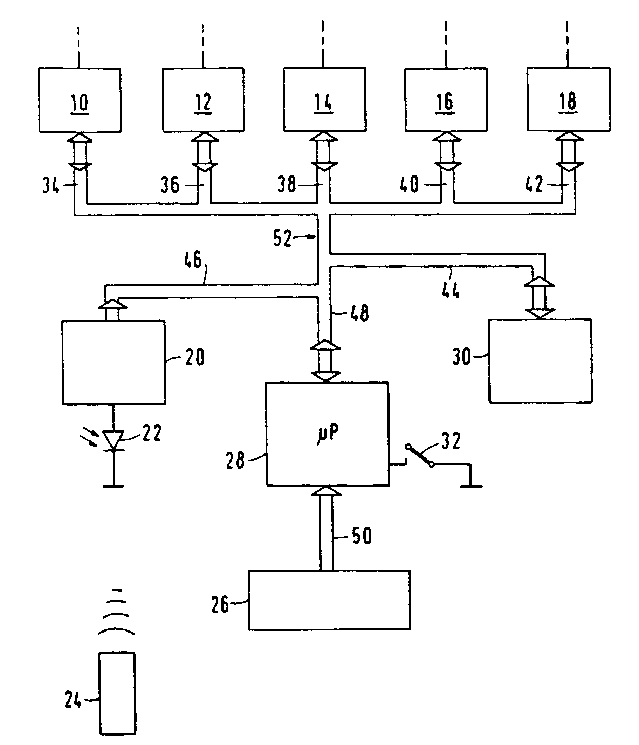

Nachfolgend wird die Erfindung anhand des in der Zeichnung dargestellten Ausführungsbeispiels näher erläutert, wobei ein Prinzip-Blockschaltbild der für die Erfindung wesentlichen Teile eines Fernsehgerätes gezeigt ist.

In der Zeichnung sind als Beispiel fünf Prozessoren 10, 12, 14, 16 und 18 dargestellt, denen beispielsweise folgende Einstellungen zugeordnet sind:
- Prozessor 10: Chroma
- Prozessor 12: Luma
- Prozessor 14: Ton
- Prozessor 16: Horizontalablenkung
- Prozessor 18: Vertikalablenkung

In dem angenommenen Beispiel sind also die Prozessoren 16 und 18 Teil der reinen Justageschaltungen, während die Prozessoren 10, 12 und 14 mittels einer Bordbedienung 26 oder einer Fernbedienung 24 für die Einstellung individueller Betriebswerte zugänglich sind.

Die voranstehend beschriebene Aufteilung muß allerdings notwendigerweise nicht so eindeutig sein, denn so kann etwa der Prozessor 10 für die manuelle Farbeinstellung auch herangezogen werden, um bei einer Justage den Weißabgleich als Grundbetriebswert herbeizuführen. Allerdings ist dieser Weißabgleich ohne zusätzliche Maßnahmen durch den Fernbedienteil 24 bzw. durch die Bordbedienung 26 nicht beeinflußbar.

Die genannten Prozessoren 10 bis 18 stehen über Datensammelleitungen 34 bis 42 und über eine Datensammelleitung 48 mit einem Mikroprozessor 28 in Verbindung, welcher über eine weitere Datensammelleitung 50 von der Bordbedienung 26 angesteuert wird.

Ferner steht der Mikroprozessor 28 in an sich bekannter Weise über eine Datensammelleitung 46 mit einem Empfangsgerät 26 in Verbindung, welches über eine Empfangsdiode 22 die von dem Fernbedienteil 24 ausgesandten Infrarotsignale für die Einstellungsschaltungen empfängt.

Schließlich steht der Mikroprozessor 28 noch über eine Datensammelleitung 44 mit einem Speicher 30 (Programmspeicher) in Verbindung, um mittels des Fernbedienteils 24 bzw. über die Bordbedienung 26 eine Programmwahl bei dem Fernsehgerät durchführen zu können.

Wenn bei der soweit beschriebenen Schaltung beispielsweise die Lautstärke verändert werden soll, wählt der Mikroprozessor 28 nach Betätigung der entsprechenden Lautstärke-Taste des Fernbedienteils 24 (bzw. der Bordbedienung 26) über die Datensammelleitung 48 und 38 mittels einer bestimmten Adresse den Prozessor 14 an, und die Lautstärke wird in gewünschter Weise verändert. In entsprechendem Sinne erfolgt die Einstellung der anderen individuellen Betriebswerte durch eine Bedienungsperson, was an sich bekannt ist.

Der Mikroprozessor 28 steht nun mit einem Schalter 32 in Verbindung, und solange dieser Schalter 32 vom Service-Techniker nicht betätigt ist, arbeitet der Mikroprozessor in gewohnter Weise im Sinne einer Einstellung von Funktionen durch einen Benutzer.

Wenn hingegen der Schalter 32 vom Service-Techniker betätigt wird, erfolgt innerhalb des Mikroprozessors 28 eine Umschaltung. Diese Umschaltung hat beispielsweise zur Folge, daß bei Betätigung der dem Farbton zugeordneten Taste auf dem Fernbedienunteil 24 (bzw. auf der Bordbedienung 26) nicht - wie dies bei nichtbetätigtem Schalter 32 der Fall gewesen wäre - der Prozessor 12 für die Farbeinstellung, sondern beispielsweise der Prozessor 16 für die horizontale Ablenkung über die zugeordnete Adresse angewählt und angesteuert wird. Das bedeutet. daß bei Betätigung der Farbtaste, wenn der Mikroprozessor 28 in den Service-Mode umgeschaltet ist, die Horizontalablenkung verändert bzw. nach einer Reparatur eingestellt werden kann.

Nach Beendigung der Justage im Reparaturfall kann der Mikroprozessor 28 durch erneute Betätigung des Schalters 32 wieder in die ursprüngliche Arbeitsweise umgeschaltet werden, so daß dann von dem Benutzer wieder die gewohnten individuellen Einstellungen vorgenommen werden können.

So weit entspricht die beschriebene Schaltung im wesentlichen der in der GB-A- 2 070 828 beschriebenen.

Die mit der Erfindung angestrebte Umschaltung des Mikroprozessors 28 wird programmäßig durch einen codierten Befehel vom Fernbedienteil aus herbeigeführt, indem bestimmte vorgegebene Tasten auf dem Fernbedienteil 24 gleichzeitig betätigt werden. Dadurch wird ein codierter Befehl erzeugt, welcher innerhalb des Mikroprozessors 28 die Umschaltung in den Service-Mode vornimmt. In ähnlicher Weise läßt sich die Rückschaltung in den üblichen Mode herbeiführen.

## Patentansprüche

1. Fernsehgerät, dessen Grundbetriebswerte in zugeordneten digitalen Justageschaltungen (16,18) voreingestellt sind, mit einem Fernbedienteil (24) mit mehreren Bedienelementen zur Ansteuerung der Einstellung von individuell geforderten oder gewünschten Betriebswerten in zugeordneten digitalen Einstellschaltungen (10,12,14) durch den Benutzer und mit einem Mode-Umschalter (32), der die Ansteuerung der Einstellschaltungen durch die Bedienelemente aufhebt und eine Ansteuerung der Justageschaltungen durch die Bedienelemente bewirkt,
dadurch gekennzeichnet,
daß die Umschaltung des Mode-Umschalters (32) mit dem Fernbedienteil (24), durch einen mittels mehrerer gleichzeitig betätigter Bedienelemente des Bedienteils (24) ausgelösten, codierten Befehl herbeiführbar ist.

## Claims

1. Television set, the basic operating values of which are preset in associated digital calibration circuits (16, 18), comprising a remote control section (24) having several operating elements for selecting the setting of individually required or desired operating values in associated digital adjustment circuits (10, 12, 14) by the user and comprising a mode switch (32) which cancels the selection of the adjustment circuits by the operating elements and causes the calibration circuits to be selected by the operating elements, characterised in that the switching of the mode switch (32) by means of the remote control section (24) can be produced by a coded command triggered by means of several simultaneously operated operating elements of the operating section (24).

## Revendications

1. Appareil de télévision dont les paramètres de fonctionnement de base sont pré-réglés dans des circuits numériques d'ajustage (16, 18), comportant une télécommande (24) à plusieurs éléments de manoeuvre pour commander le réglage des paramètres de fonctionnement individuels, demandés ou souhaités, dans des circuits numériques de réglage (10, 12, 14) par l'utilisateur et un commutateur de mode (32) qui supprime la commande des circuits de réglage par les éléments de manoeuvre et assure la commande des circuits d'ajustage par les éléments de manoeuvre,
caractérisé en ce que
la commutation du commutateur de mode (32) par la télécommande (24) se fait à l'aide d'un ordre codé déclenché par plusieurs éléments de manoeuvre actionnés simultanément sur la télécommande (24).
